# EUROPEAN PATENT APPLICATION

(11) **EP 4 345 894 A1**
(43) Date of publication of application: **03.04.2024**
(21) Application number: 23187397.7
(22) Date of filing: 25.07.2023
(51) Int. Cl.: H01L 23/522

(54) **BURIED VIA THROUGH FRONT-SIDE AND BACK-SIDE METALLIZATION LAYERS WITH OPTIONAL CYLINDRICAL MIM CAPACITOR**

(30) Priority: 28.09.2022 US 202217955203
(71) Applicant: INTEL Corporation, Santa Clara, CA 95054 (US)
(72) Inventor: SHARMA, Abhishek, Portland, 97229 (US); Ghani, Tahir, Portland, 97229 (US); MURTHY, Anand, Portland, 97229 (US); Gomes, Wilfred, Portland, 97229 (US); Suthram, Sagar, Portland, 97229 (US); Ranade, Pushkar, San Jose, 95134 (US)
(74) Representative: Goddar, Heinz J.

(57) **Abstract**

An integrated circuit (IC) die includes a plurality of front-side metallization layers including a first front-side metallization layer and one or more additional front-side metallization layers, a plurality of back-side metallization layers formed on the plurality front side metallization layers including a first back-side metallization layer and one or more additional back-side metallization layers, wherein the first front-side metallization layer is proximate to the first back-side metallization layer, and a vertical metallization structure formed through at least the first front-side metallization layer and the first back-side metallization layer, wherein the vertical metallization structure electrically connects a first metallization structure on one of the one or more additional front-side metallization layers to a second metallization structure on one of the one or more additional back-side metallization layers. Other embodiments are disclosed and claimed.

## Description

### BACKGROUND

There is an ongoing need for improved computational devices to enable ever increasing demand for modeling complex systems, providing reduced computation times, and other considerations. In some contexts, scaling features of integrated circuits has been a driving force for such improvements. Other advancements have been made in materials, device structure, circuit layout, and so on. In particular, there is an ongoing desire to improve interconnect and power delivery structures that are included in or otherwise support operation of integrated circuits. It is with respect to these and other considerations that the present improvements have been needed. Such improvements may become critical as the desire to improve computational efficiency become even more widespread.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIG. 1 illustrates a block diagram view of an example integrated circuit (IC) die;
FIG. 2 illustrates a block diagram view of another example IC;
FIG. 3 illustrates a block diagram of an example of a system;
FIGS. 4A to 4B illustrate cross sectional side views of another example IC die;
FIGS. 5A to 5B illustrate cross sectional side views of another example IC die;
FIGS. 6A to 6C illustrate cross sectional side views and a plan view of another example IC die;
FIG. 7 illustrates a cross-sectional view of a low-temperature IC system using dieand package-level active cooling that includes front-side/back-side via and/or capacitor (FBVC) structures;
FIG. 8 illustrates a view of an example two-phase immersion cooling system for low-temperature operation of an IC die;
FIGS. 9A to 9B illustrates various processes or methods for forming FBVC structures on an IC die;
FIG. 10 illustrates a diagram of an example data server machine employing an IC die with FBVC; and
FIG. 11 is a block diagram of an example computing device, all in accordance with at least some implementations of the present disclosure.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the spirit and scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure. The term "aligned" (i.e., vertically or laterally) indicates at least a portion of the components are aligned in the pertinent direction while "fully aligned" indicates an entirety of the components are aligned in the pertinent direction.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified, the use of the ordinal adjectives "first," "second," and "third," etc., to describe a common object, merely indicate that different instances of like objects to which are being referred and are not intended to imply that the objects so described must be in a given sequence, either temporally, spatially, in ranking, or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Thus, cross-sectional and profile views are taken in the *x-z* and *y-z* planes, and plan views are taken in the *x-y* plane. Typically, profile views in the *x-z* plane are cross-sectional views. Where appropriate, drawings are labeled with axes to indicate the orientation of the figure.

Materials, structures, and techniques are disclosed to improve interconnect between front-side and back-side layers in an integrated circuit (IC) die. One problem is that typical interconnects between front-side and back-side layers involve a via that may connect one of the lower front-side layers (e.g., M0, M1, etc.) only to a first metal layer of the back-side (e.g., BM0). Power may be generally provided from a back of the IC die through metallization structures to components formed in the front-side. A problem is that components of the IC die may suddenly consume a lot of power from these metallization structures and whatever charge is available through the metallization structure may get drained out before the charge can fully be replenished. Planar capacitors may be formed in the back-side layers to help with power delivery. A problem is that planar capacitors consume substantial area that may otherwise be utilized for other circuits or signals. Some embodiments may overcome one or more of the foregoing problems.

Some embodiments may provide technology for a via that spans one of the metal layers on the front-side to one of the metal layers on the back-side. In some embodiments, the vias may be formed in a grid pattern or a non-uniform pattern of vias that are connected from a metal layer internal to the front-side to a metal layer internal to the back-side. In some embodiments, one or more of such front-side/backside vias may be further formed into a cylindrical metal-insulator-metal (MIM) capacitor. For example, a central portion inside the via and an outer portion of the via may be configured as metal electrodes of a cylindrical capacitor and a dielectric material (e.g., oxide) may be disposed between the cylindrical electrodes. Capacitors may be useful for a wide variety of circuits and applications including, for example, energy storage, signal filtering, and high-frequency tuning applications. Non-limiting examples of types of capacitors for an embodiment of a cylindrical MIM capacitor include a decoupling capacitor, a backup capacitor, a transient load decoupling capacitor, a power backup capacitor, surge capacitor. Suitably configured, the cylindrical MIM capacitors may improve the power delivery. The cylindrical MIM capacitors may be configured to store enough charge such that a sudden demand for extra charge may be delivered immediately. Advantageously, as compared to a planar MIM capacitor, embodiments of a cylindrical MIM capacitor may occupy less area.

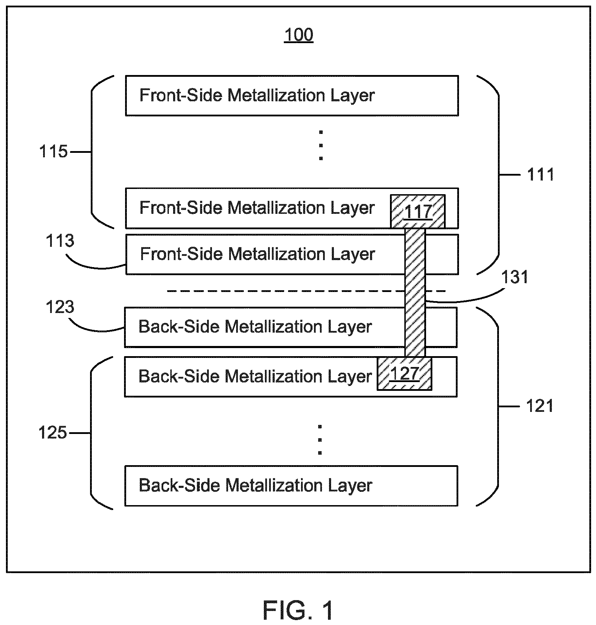

FIG. 1 shows an illustrative cross-sectional side view of an example integrated circuit (IC) die 100 that includes a front-side/back-side via and/or capacitor (FBVC) structure in accordance with some embodiments. In this example, the IC die 100 includes a plurality of front-side metallization layers 111 including a first front-side metallization layer 113 and one or more additional front-side metallization layers 115, a plurality of back-side metallization layers 121 formed on the plurality front side metallization layers 111 including a first back-side metallization layer 123 and one or more additional back-side metallization layers 125. The first front-side metallization layer 113 is proximate to the first back-side metallization layer 123. The IC die 100 further includes a vertical metallization structure 131 formed through at least the first front-side metallization layer 113 and the first back-side metallization layer 123. The vertical metallization structure 131 electrically connects a first metallization structure 117 on one of the one or more additional front-side metallization layers 115 to a second metallization structure 127 on one of the one or more additional back-side metallization layers 125.

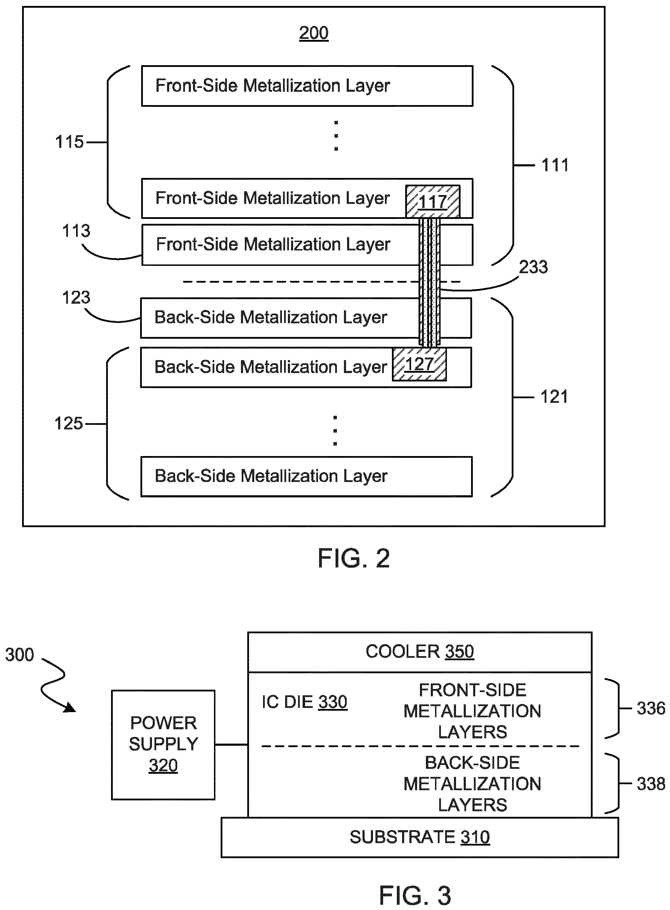

With reference to FIG. 2, an example integrated circuit (IC) die 200 that includes FBVC structures may be similarly configured as the IC die 100, with similar elements having like reference numerals. In this example, the IC die 200 further includes a cylindrical capacitor structure 233 formed in a vertical metallization structure. For example, the cylindrical capacitor structure 233 may comprise a cylindrical MIM capacitor structure 233. In some embodiments, one of the first metallization structure 117 and the second metallization structure 127 may be configured to be coupled to a power source. In some embodiments, the cylindrical MIM capacitor structure 233 may be formed proximate to a component that has an expected surge in power demand. For example, the cylindrical MIM capacitor structure 233 may be within ten nanometers (10 nm) to one micrometer (1 um) of circuitry of a processor component, a memory component, an input/output transmission component, etc., that may be subject to surge demands in power.

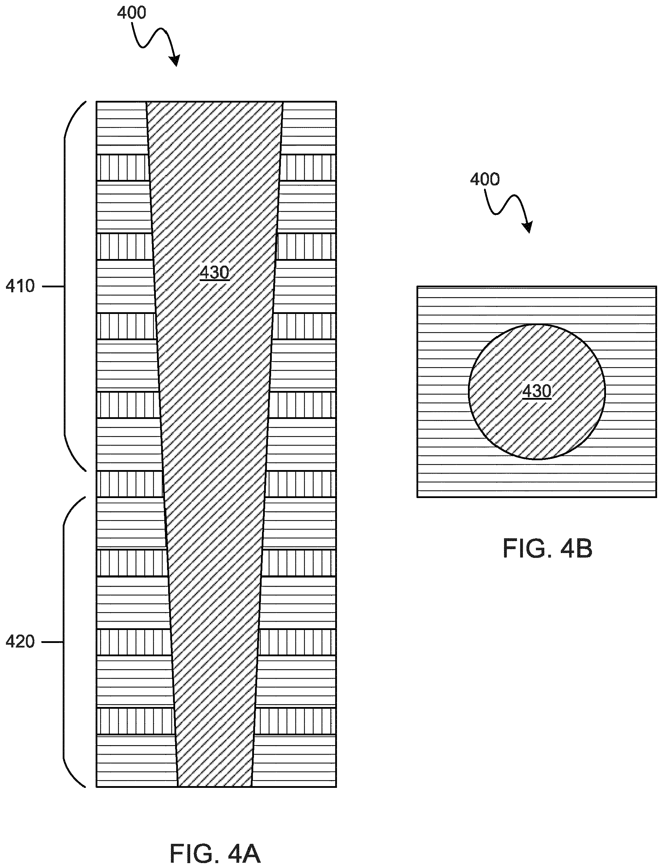

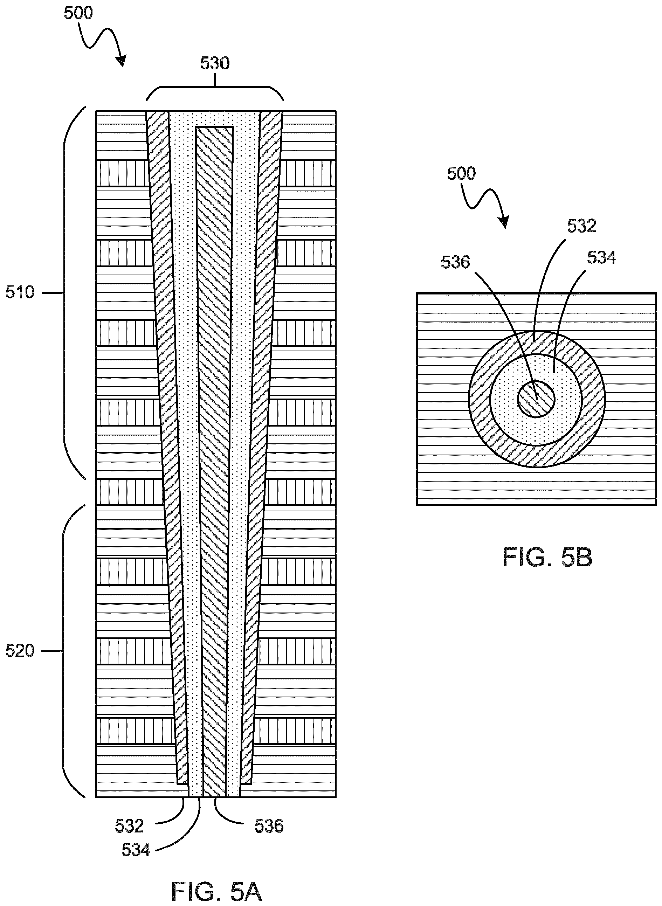

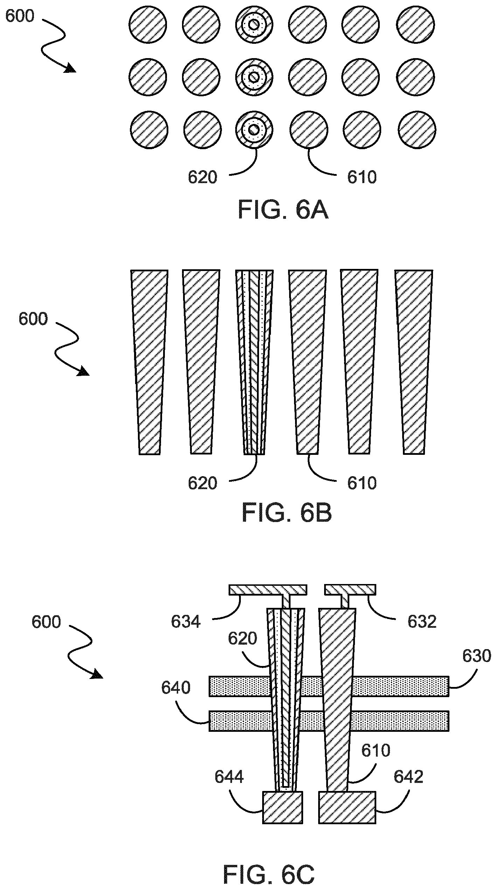

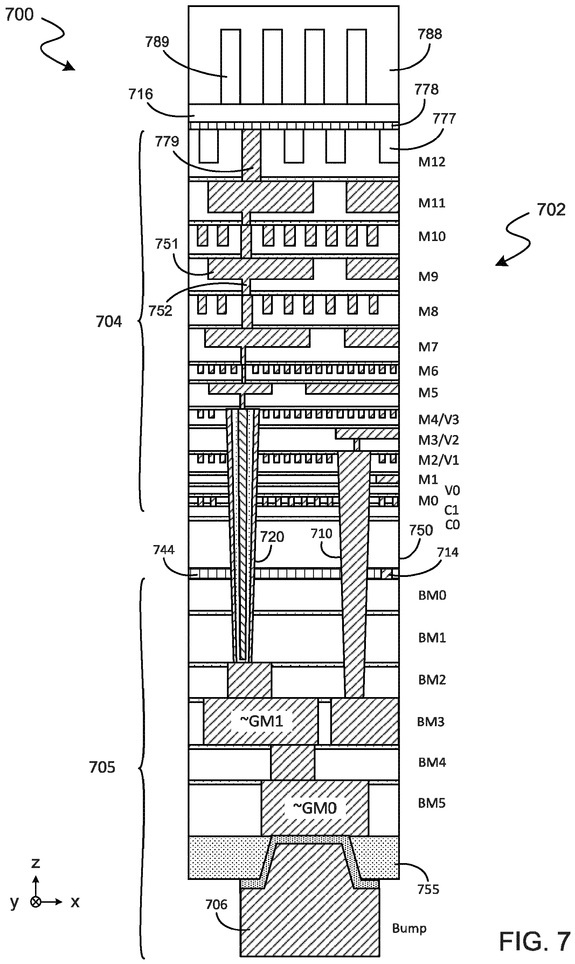

FIG. 3 shows a block diagram view of an example of a system 300 that includes a substrate 310, a power supply 320, and an IC die 330 attached to the substrate 310 and coupled to the power supply 320. The system 300 further includes a cooler 350 thermally coupled to the IC die 330 (e.g., although shown coupled on the front-side, the cooler 350 may be coupled to the back-side, or the IC die 330 may be immersed in the cooler 350, etc.). The IC die 330 may be similarly configured as any of the various ICs described herein including, for example, the IC die 100 (FIG. 1), the IC die 200 (FIG. 1), the IC die 400 (FIGS. 4A-B), the IC die 500 (FIGS. 5A-B), the IC die 600 (FIGS. 6A-C), and the IC die 702 (FIG. 7). For example, the IC die 330 may include a plurality of front-side metallization layers 336 including a first front-side metallization layer and one or more additional front-side metallization layers, a plurality of back-side metallization layers 338 formed on the plurality front side metallization layers including a first back-side metallization layer and one or more additional back-side metallization layers, wherein the first front-side metallization layer is proximate to the first back-side metallization layer, and one or more vertical metallization structures formed through at least the first front-side metallization layer and the first back-side metallization layer, where the vertical metallization structure(s) electrically connect respective first metallization structures on any of the additional front-side metallization layers to respective second metallization structures on any of the additional back-side metallization layers.

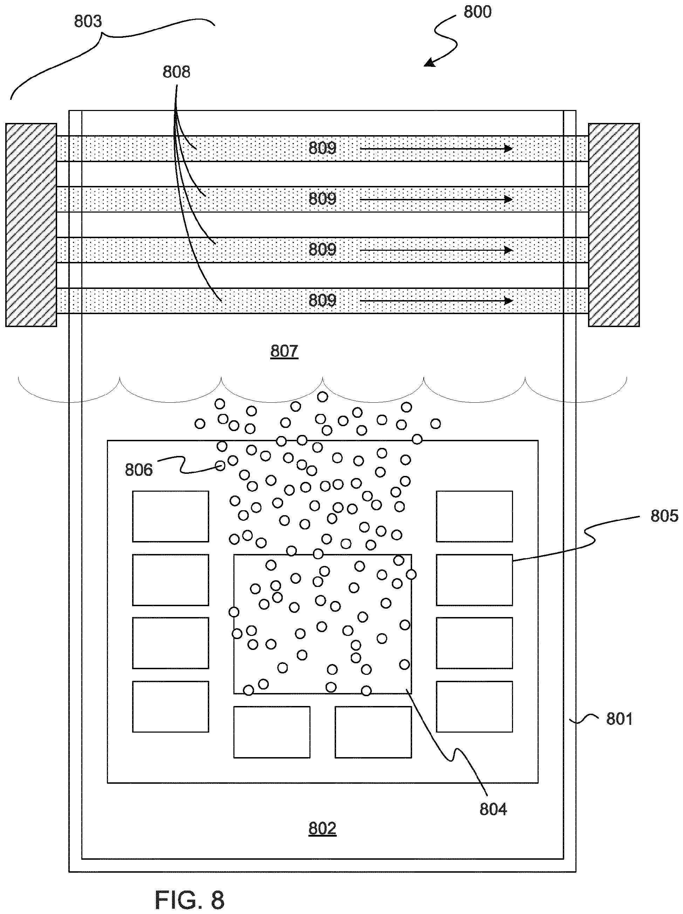

In some embodiments, the system 300 may include one or more cylindrical capacitor structures optionally formed in the vertical metallization structure(s) (e.g., cylindrical MIM capacitors). Various of the first metallization structure(s) and the second metallization structure(s) may be configured to be coupled to a power source. In some embodiments, the cylindrical MIM capacitor(s) may be formed proximate to a component that has an expected surge in power demand (e.g., to meet that demand). In some embodiments, the system 300 may further include a plurality of cylindrical MIM capacitors formed through the first front-side metallization layer and the first back-side metallization layer respectively formed proximate to a plurality of components that have an expected surge in power demand. Any suitable substrate technology may be utilized for the substrate 310 including, for example, the substrates described herein in connection with FIGS. 7 and 8 (e.g., substrate 805). In some embodiments, the IC die 330 may be coupled to the power supply 320 through the substrate 310.

FIGS. 4A to 4B show an example cross-section and plan view of an IC die 400 that includes a FBVC structure in accordance with some embodiments. The IC die 400 includes alternating layers of dielectric material, some of include front-side metallization layers 410 and others of which include back-side metallization layers 420. A via 430 is formed through the include front-side metallization layers 410 and the back-side metallization layers 420 (e.g., to provide a connection between those layers). In some embodiments, a hole is formed through the front-side metallization layers 410 and the back-side metallization layers 420, and then the hole is filled with metal. Any suitable techniques may be utilized to fabricate the via 430 including, for example, atomic layer deposition (ALD), chemical vapor deposition (CVD), physical vapor deposition (PVD), etc. In some embodiments, a breakthrough etch process may be utilized to form the hole through each of the front-side metallization layers 410 and the back-side metallization layers 420.

FIGS. 5A to 5B show an example cross-section and plan view of an IC die 500 that includes a FBVC structure in accordance with some embodiments. The IC die 500 includes alternating layers of dielectric material, some of include front-side metallization layers 510 and others of which include back-side metallization layers 520. A cylindrical MIM capacitor 530 is formed through the include front-side metallization layers 510 and the back-side metallization layers 520 (e.g., to connect a capacitor between those layers). In some embodiments, a hole is formed through the front-side metallization layers 510 and the back-side metallization layers 520, a metal liner 532 is deposited on the sidewalls of the hole, a dielectric liner 534 is deposited on the metal liner 532, and then the dielectric liner 534 is filled with metal 536. Any suitable techniques may be utilized to fabricate the cylindrical MIM capacitor 530 including, for example, ALD, CVD, PVD, etc. In some embodiments, a breakthrough etch process may be utilized to form the hole through each of the front-side metallization layers 510 and the back-side metallization layers 520.

Some embodiments may provide a buried power rail with cylindrical MIM capacitors. A planar MIM capacitor occupies substantial track space that may otherwise be utilized for power and data signals. Some embodiments utilize cylindrical capacitors around power vias to provide immediate surge currents. Suitably configured cylindrical MIM capacitors may meet current requirements for anywhere between one-tenth (0.1) amp per millimeter squared to ten (10) amps per millimeter squared, may exhibit an amount of capacitance per capacitor of anywhere between one-tenth (0.1) femtofarad (fF) up to one hundred (100) fF, may have a height of between fifty nanometers (50 nm) and ten micrometers (10 um), and may recharge in anywhere between one (1) and one hundred (100) clock cycles, depending on a pitch of the through-silicon vias (TSVs) and a height of the TSVs. Some TSV arrays for power may utilize a combination of two arrays, where one array adds a large sheet of high-k dielectric material and another array replaces the vias with cylindrical MIM capacitors.

FIGS. 6A to 6C show an example of an IC die 600 that includes FBVC structures. In FIGS. 6A and 6B, vias 610 and cylindrical MIM capacitor 620 are arranged in a grid pattern, although any suitable pattern may be utilized. In some embodiments, initial processing may form holes for each of the vias and capacitors, and an independent mask may be utilized to convert selected ones of the vias into cylindrical MIM capacitors. FIG. 6C shows how the vias 610 and cylindrical MIM capacitors 620 pass through at least one front-side metallization layer 630 and one back-side metallization layer 640 to connect respective front-side metallization structures 632, 634 to respective back-side metallization structures 642, 644. The connection(s) may be from any metal layer on the front-side to any metal layer on the back-side and through any number of intervening layers. In some embodiments, the back-side metallization structure 644 may be a power connection (e.g., a voltage source or ground).

In some embodiments, ICs with FBVC structures may be integrated into a low-temperature system. Lower temperatures enhance conduction in many materials and can enable the use of, e.g., different materials and structures (such as smaller transistor channels). A number of structures may be used to lower the system temperature and so allow for the use of, e.g., smaller conducting structures. Active cooling structures can be used to lower system temperatures to below ambient temperature, even to well below ambient temperature. Active cooling structures can include thermoelectric coolers. In some embodiments, active cooling structures include stacks of alternating p- and n-type semiconductor materials. In some embodiments, active cooling structures flow cooling fluids through channels, including microchannels, thermally coupled to IC packages. In some embodiments, active cooling structures include channels thermally coupled to IC dies 100. In some embodiments, active cooling structures include channels on one or more sides of IC dies 100. In some embodiments, active cooling structures include channels within IC dies 100. In some embodiments, active cooling structures include two-phase cooling. In some embodiments, active cooling structures include low-boiling-point fluids. In some embodiments, active cooling structures include refrigerants as cooling fluids. In some embodiments, active cooling structures lower system temperatures to below 0°C.

Embodiments may advantageously improve power delivery with FBVC structures and increase the amount of area available for other circuits/signals in a computationally intensive system and/or large wafer level system. Embodiments that involve a large wafer level system or that are computationally intensive may be particularly applicable for low-temperature systems. For some embodiments, low temperature operation may involve less droop due to reduced transmission line resistance and accordingly smaller cylindrical capacitors may be suitable as compared to room temperature operation.

FIG. 7 illustrates a cross-sectional view of a low-temperature IC system 700 using die- and package-level active cooling, that includes FBVC structures in accordance with some embodiments. In the example of IC system 700, IC die 702 includes active-cooling structures or components as provided by both die-level microchannels 777 and package-level active-cooling structure 788. IC system 700 includes a lateral surface along the *x-y* plane that may be defined or taken at any vertical position of IC system 700. The lateral surface of the *x-y* plane is orthogonal to a vertical or build-up dimension as defined by the z-axis. In some embodiments, IC system 700 may be formed from any substrate material suitable for the fabrication of transistor circuitry. In some embodiments, a semiconductor substrate is used to manufacture FBVC structures and other transistors and components of IC system 700. The semiconductor substrate may include a wafer or other piece of silicon or another semiconductor material. Suitable semiconductor substrates include, but are not limited to, single crystal silicon, polycrystalline silicon and silicon on insulator (SOI), as well as similar substrates formed of other semiconductor materials, such as gallium arsenide. The substrate may also include semiconductor materials, metals, dielectrics, dopants, and other materials commonly found in semiconductor substrates.

In FIG. 7, IC system 700 includes an IC die 702, which is a monolithic IC with FBVCs as described herein, including front-side metallization layers 704 (or front-side interconnect layers), and optional back-side metallization layers 705 (or back-side interconnect layers). As shown, IC die 702 may include one or more vias 710 and one or more cylindrical MIM capacitors 720 that pass through the dielectric layer 750 and multiple layers of both the front-side metallization layers 704 and the back-side metallization layers 705. In some embodiments, front-side metallization layers 704 provide signal routing to the non-planar transistors and back-side metallization layers 705 provide power delivery, as enabled by through-contacts 714, and vias 710. In some embodiments, IC system 700 further includes a package-level cooling structure 788, which may be deployed on or over front-side metallization layers 704 (as shown) or on or over a back-side of IC die 702. In some embodiments, package-level cooling structure 788 is coupled to IC die 702 by an adhesion layer 716. IC system 700 may also be deployed without back-side metallization layers 705 shown in FIG. 7. In such embodiments, signal routing and power are provided to circuits of the IC die 702 via front-side metallization layers 704. However, use of back-side metallization layers 705 may offer advantages.

The circuits of the IC die 702 are connected and thermally coupled by metallization, e.g., metal heat spreader 744, to the entire metallization structure by through-contacts 714. In this way, circuits of the IC die 702 are thermally coupled to both the die-level active-cooling structures (of die-level microchannels 777) and package-level active-cooling structure 788.

Interconnectivity of transistors, signal routing to and from circuitry of the IC die 702, vias 710 (e.g., and other vias), etc., power delivery to circuitry of the IC die 702, etc., and routing to an outside device (not shown), is provided by front-side metallization layers 704, optional back-side metallization layers 705, and package-level interconnects 706. In the example of FIG. 7, package-level interconnects 706 are provided on or over a back-side of IC die 702 as bumps over a passivation layer 755, and IC system 700 is attached to a substrate (and coupled to signal routing to, power delivery, etc.) by package-level interconnects 706. However, package-level interconnects 706 may be provided using any suitable interconnect structures such as bond pads, solder bumps, etc. Furthermore, in some embodiments, package-level interconnects 706 are provided on or over a front-side of IC die 702 (i.e., over front-side metallization layers 704) and package-level cooling structure 788 is provided on or over a back-side of IC die 702.

In IC system 700, IC die 702 includes die-level, active-cooling as provided by die-level microchannels 777. Die-level microchannels 777 are to convey a heat transfer fluid therein to remove heat from IC die 702. The heat transfer fluid may be any suitable liquid or gas. In some embodiments, the heat transfer fluid is liquid nitrogen operable to lower the temperature of IC die 702 to a temperature at or below about -196°C. In some embodiments, the heat transfer fluid is a fluid with a cryogenic temperature operating window (e.g., about -180°C to about - 70°C). In some embodiments, the heat transfer fluid is one of helium-3, helium-4, hydrogen, neon, air, fluorine, argon, oxygen, or methane.

As used herein, the term "microchannels" indicates a channel to convey a heat transfer fluid with the multiple microchannels providing discrete separate channels or a network of channels. Notably, the plural microchannels does not indicate separate channel networks are needed. Such die-level microchannels 777 may be provided in any pattern in the *x-y* plane such as serpentine patterns, patterns of multiple parallel die-level microchannels 777, or the like. Die-level microchannels 777 couple to a heat exchanger (not shown) that removes heat from and cools the heat transfer fluid before re-introduction to die-level microchannels 777. The flow of fluid within die-level microchannels 777 may be provided by a pump or other fluid flow device. The operation of the heat exchanger, pump, etc. may be controlled by a controller.

In the illustrated embodiment, die-level microchannels 777 are implemented at metallization level M12. In other embodiments, die-level microchannels 777 are implemented over metallization level M12. Die-level microchannels 777 may be formed using any suitable technique or techniques such as patterning and etch techniques to form the void structures of die-level microchannels 777 and passivation or deposition techniques to form a cover structure 778 to enclose the void structures. As shown, in some embodiments, the die-level, active-cooling structure of IC system 700 includes a number of die-level microchannels 777 in IC die 702 and over a number of front-side metallization layers 704. As discussed, die-level microchannels 777 are to convey a heat transfer fluid therein. In some embodiments, a metallization feature 779 of metallization layer M12 is laterally adjacent to die-level microchannels 777. For example, metallization feature 779 may couple to a package-level interconnect structure (not shown) for signal routing for IC die 702. In some embodiments, a passive heat removal device such as a heat sink or the like may be used instead of or in addition to package-level cooling structure 788. In some embodiments, package-level cooling structure 788 is not deployed in IC system 700.

As used herein, the term "metallization layer" describes layers with interconnections or wires that provide electrical routing, generally formed of metal or other electrically and thermally conductive material. Adjacent metallization layers may be formed of different materials and by different methods. Adjacent metallization layers, such as metallization interconnects 751, are interconnected by vias, such as vias 752, that may be characterized as part of the metallization layers or between the metallization layers. As shown, in some embodiments, front-side metallization layers 704 are formed over and immediately adjacent transistors. The back-side is then the opposite side, which may be exposed during processing by attaching the front-side to a carrier wafer and exposing the back-side (e.g., by back-side grind or etch operations) as known in the art.

In the illustrated example, front-side metallization layers 704 include M0, V0, M1, M2/V1, M3/V2, M4/V3, and M4-M12. However, front-side metallization layers 704 may include any number of metallization layers such as eight or more metallization layers. Similarly, back-side metallization layers 705 include BM0, BM1, BM2, BM3, BM4, and BM5. However, back-side metallization layers 705 may include any number of metallization layers such as two to ten metallization layers. Front-side metallization layers 704 and back-side metallization layers 705 are embedded within dielectric materials. Furthermore, optional MIM devices such as diode devices may be provided within back-side metallization layers 705. Other devices such as capacitive memory devices may be provided within front-side metallization layers 704 and/or back-side metallization layers 705.

IC system 700 includes package-level active-cooling structure 788 having package-level microchannels 789. Package-level microchannels 789 are to convey a heat transfer fluid therein to remove heat from IC die 702. The heat transfer fluid may be any suitable liquid or gas as discussed with respect to die-level microchannels 777. Package-level microchannels 789 may be provided in any pattern in the *x-y* plane such as serpentine patterns, patterns of multiple parallel package-level microchannels 789, etc. Package-level microchannels 789 couple to a heat exchanger (not shown) that removes heat from and cools the heat transfer fluid before re-introduction to package-level microchannels 789. The flow of fluid within package-level microchannels 789 may be provided by a pump or other fluid-flow device. The operation of the heat exchanger, pump, etc. may be controlled by a controller. In the illustrated embodiment, package-level active-cooling structure 788 is a chiller mounted to IC die 702 such that the chiller has a solid body having microchannels therein to convey a heat transfer fluid.

In some embodiments, the heat-removal fluid deployed in die-level microchannels 777 and package-level active-cooling structure 788 are coupled to the same pump and heat exchanger systems. In such embodiments, the heat removal fluid conveyed in both die-level microchannels 777 and package-level active-cooling structure 788 are the same material. Such embodiments may advantageously provide simplicity. In other embodiments, the heat removal fluids are controlled separately. In such embodiments, the heat removal fluids conveyed by die-level microchannels 777 and package-level active-cooling structure 788 may be the same or they may be different. Such embodiments may advantageously provide improved flexibility.

As discussed, IC system 700 includes IC die 702 and optional die-level and package-level active-cooling structures operable to remove heat from IC die 702 to achieve a very low operating temperature of IC die 702. As used herein, the term "very low operating temperature" indicates a temperature at or below 0°C, although even lower temperatures such as an operating temperature at or below -50°C, an operating temperature at or below -70°C, an operating temperature at or below -100°C, an operating temperature at or below -180°C, or an operating temperature at or below -196°C may be used. In some embodiments, the operating temperature is in a cryogenic temperature operating window (e.g., about -180°C to about -70°C). The active-cooling structure may be provided as a package-level structure (i.e., separable from IC die 702), as a die-level structure (i.e., integral to IC die 702), or both. In some embodiments, IC die 702 is deployed in a cold environment, formed using sufficiently conductive materials, etc. and an active-cooling structure is not used.

FIG. 8 illustrates a view of an example two-phase immersion cooling system 800 for low-temperature operation of an IC die, in accordance with some embodiments. As shown, two-phase immersion cooling system 800 includes a fluid containment structure 801, a low-boiling point liquid 802 within fluid containment structure 801, and a condensation structure 803 at least partially within fluid containment structure 801. As used herein, the term "low-boiling point liquid" indicates a liquid having a boiling point in the very low temperature ranges discussed. In some embodiments, the low-boiling point liquid is one of helium-3, helium-4, hydrogen, neon, air, fluorine, argon, oxygen, or methane.

In operation, a heat generation source 804, such as an IC package including any of IC dies or systems 100, 200, 300, 400, 500, 600, 700 as discussed herein is immersed in low-boiling point liquid 802. In some embodiments, IC dies or systems 100, 200, 300, 400, 500, 600, 700 as deployed in two-phase immersion cooling system 800 do not include additional active cooling structures, although such die-level or package-level active cooling structures may be used in concert with two-phase immersion cooling system 800. In some embodiments, when deployed in two-phase immersion cooling system 800, package-level active-cooling structure 788 is a heat sink, a heat dissipation plate, a porous heat dissipation plate or the like.

Notably, IC die 702 (or IC die 100, 200, 300, 400, 500, 600), is the source of heat in the context of two-phase immersion cooling system 800. For example, IC die 702 may be packaged and mounted on electronics substrate 805. Electronic substrate 805 may be coupled to a power supply (not shown) and may be partially or completely submerged in low-boiling point liquid 802.

In operation, the heat produced by heat generation source 804 vaporizes low-boiling point liquid 802 as shown in vapor or gas state as bubbles 806, which may collect, due to gravitational forces, above low-boiling point liquid 802 as a vapor portion 807 within fluid containment structure 801. Condensation structure 803 may extend through vapor portion 807. In some embodiments, condensation structure 803 is a heat exchanger having a number of tubes 808 with a cooling fluid (i.e., a fluid colder than the condensation point of vapor portion 807) shown by arrows 809 that may flow through tubes 808 to condense vapor portion 807 back to low-boiling point liquid 802. In the IC system of FIG. 8, package-level active-cooling structure 788 includes a passive cooling structure such as a heat sink for immersion in low-boiling point liquid 802.

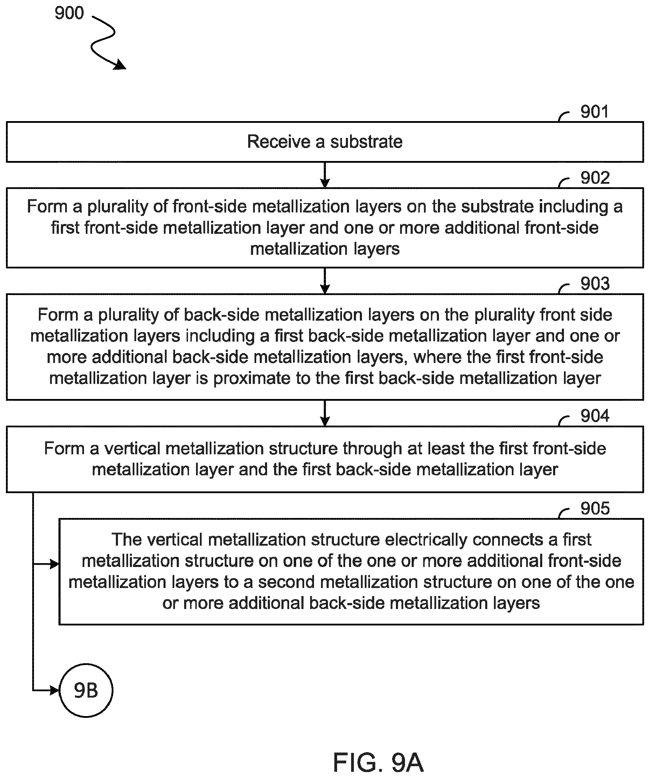

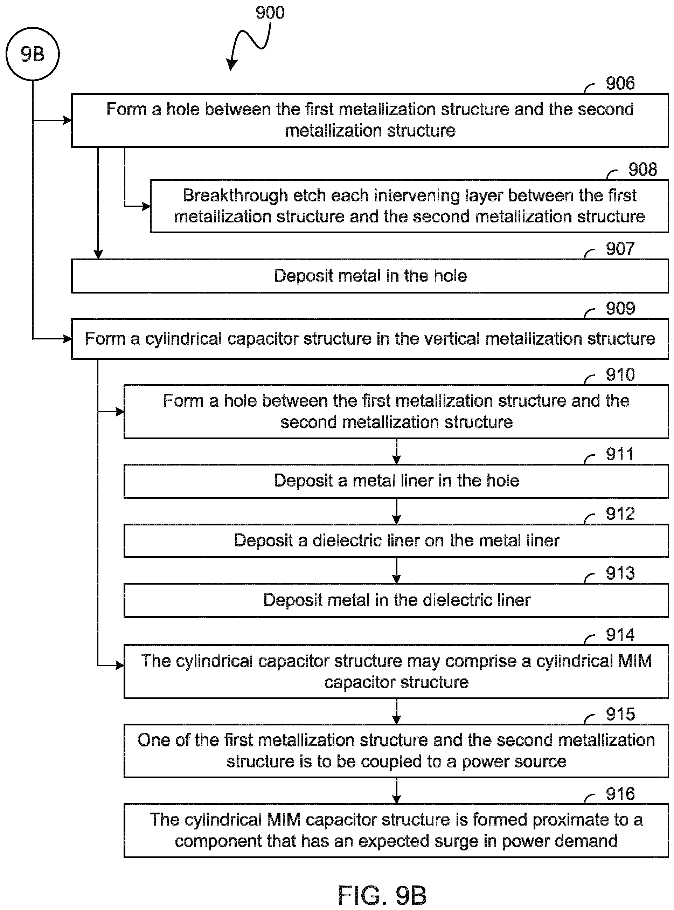

FIGS. 9A to 9B illustrate various processes or methods 900 for forming FBVCs on an IC die, in accordance with some embodiments. FIGS. 9A to 9B show methods 900 that includes operations 901-916. Some operations shown in FIGS. 9A to 9B are optional. FIGS. 9A to 9B show an example sequence, but the operations can be done in other sequences as well, and some operations may be omitted. Some operations can also be performed multiple times before other operations are performed. Some operations may be included within other operations. Methods 900 generally entail forming a hole through front-side and back-side metallization layers and forming a via or a capacitor in the hole.

In operation 901, a substrate is received. The substrate is a planar platform and may already include dielectric and metallization structures. The substrate may be one of many layers in an IC die, and may itself have many layers. The substrate may be above other layers in the IC die (all or of a portion of which may be subsequently removed in back-side metallization contexts), and other layers may subsequently be formed in or over the substrate.

The substrate may include any suitable material or materials. Any suitable semiconductor or other material can be used. Transistors in the IC die may be of the same material as the substrate or, e.g., deposited on the substrate. The substrate may include a semiconductor material that transistors can be formed out of and on, including a crystalline material. In some examples, the substrate may include monocrystalline silicon (Si), germanium (Ge), silicon germanium (SiGe), a III-V alloy material (e.g., gallium arsenide (GaAs)), a silicon carbide (SiC), a sapphire (Al2O3), or any combination thereof. In some embodiments, the substrate includes crystalline silicon and subsequent components are also silicon.

In operation 902, a plurality of front-side metallization layers are formed on the substrate including a first front-side metallization layer and one or more additional front-side metallization layers. The plurality of front-side metallization layers need not be formed before, e.g., other layers of the IC die. Forming the plurality of front-side metallization layers and other layers of the IC die may include forming transistors, resistors, and interconnections, e.g., between them and with external structures, including power, signal, data, ground, etc. lines. At least some of these structures may be conventional and known methods may be used.

Transistors can be formed from the same material as the substrate or, e.g., deposited on the substrate. In some embodiments, the substrate is crystalline silicon and transistors in the first layer are formed by etching back the substrate to form transistor structures, e.g., non-planar structures, such as fins for access transistor channels. In some embodiments, transistors comprise polycrystalline silicon, which may be deposited over other materials. Other semiconductor materials may be deposited as well, on the substrate or over other structures on the substrate. Such semiconductor materials can be any material suitable for forming a transistor channel, e.g., for an access transistor, but some materials will be preferred for their manufacturing properties, e.g., the capability to be deposited easily, in a well-controlled manner, and in thin layers.

Forming the plurality of front-side metallization layers may include forming ultrathin structures, such as nanowires, nanoribbons, or nanosheets, for transistor channels. In some embodiments, one or a few monolayers of semiconductor materials are deposited over the substrate or other structures. In some embodiments, less than 2 nm of semiconductor material is deposited as a film. In some embodiments, a transition-metal dichalcogenide (TMD) material is deposited to form access transistors. TMDs can be 2D materials, e.g., forming monolayers of semiconductor materials. 2D materials may be deposited on structures, such as backbone features, deposited on the substrate.

The methods for forming transistors may vary with transistor function. TFTs for use as pull-up transistors may be formed as parasitic devices deposited over other structures in some layers. In some embodiments, forming transistors includes depositing amorphous or polycrystalline metal oxides. In some embodiments, a thin, metal-oxide film is deposited that may be semiconducting substantially as-deposited, and/or following some subsequent activation process, such as a thermal anneal.

Other structures, e.g., resistors and metallization, may also be deposited or otherwise formed from such materials, and such forming may be done throughout the forming operations of transistors and other structures. Pull-up resistors may be formed from the substrate material or, e.g., by depositing polycrystalline silicon or other material over the substrate. Other structures, e.g., access transistor gate electrodes, may be formed such that convenient connections can be made to associated structures in the first layer. Metallization may be formed before and after, and interleaved throughout, the forming of other structures.

In operation 903, a plurality of back-side metallization layers are formed on the plurality front side metallization layers including a first back-side metallization layer and one or more additional back-side metallization layers, where the first front-side metallization layer is proximate to the first back-side metallization layer.

The plurality of back-side metallization layers may be formed in or on the substrate and in a layer vertically adjacent the first front-side metallization layer. The plurality of back-side metallization layers may be formed after the plurality of front-side metallization layers. Structures in the plurality of back-side metallization layers may be deposited or grown over the top of the plurality of back-side metallization layers.

In operation 904, a vertical metallization structure is formed through at least the first front-side metallization layer and the first back-side metallization layer at box 904. For example, the vertical metallization structure electrically connects a first metallization structure on one of the one or more additional front-side metallization layers to a second metallization structure on one of the one or more additional back-side metallization layers at box 905.

Following this operation, the first metallization structure and second metallization structure on respective front-side and back-side layers are electrically connected. In some embodiments, the vertical metallization structure may be a metallized via connection on one side of the layers beyond the horizontal edges or boundaries of respective circuits. In some embodiments, two of the connected circuits are vertically aligned, and other connected circuits in both layers are not vertically aligned. The vertical metallization structure, e.g., a via, can be formed as part of traditional or other methods, e.g. single or dual damascene techniques, etc.

In operation 906 (e.g., to form the vertical metallization structure), a hole is formed between the first metallization structure and the second metallization structure. At operation 907, metal is deposited in the hole at box 907. In operation 908 (e.g., to form the hole), each intervening layer between the first metallization structure and the second metallization structure is breakthrough etched.

In operation 909, a cylindrical capacitor structure is formed in the vertical metallization structure at box 909. In some embodiments, a hole is formed between the first metallization structure and the second metallization structure at operation 910, a metal liner is deposited in the hole at operation 911, a dielectric liner is deposited on the metal liner at operation 912, and metal is deposited in the dielectric liner at operation 913. For example, forming the hole may comprise breakthrough etching each intervening layer between the first metallization structure and the second metallization structure (e.g., similar to operation 908).

In some embodiments, the cylindrical capacitor structure may comprise a cylindrical MIM capacitor structure at box 914. In some embodiments, one of the first metallization structure and the second metallization structure is to be coupled to a power source at box 915. In some embodiments, the cylindrical MIM capacitor structure is formed proximate to a component that has an expected surge in power demand at box 916.

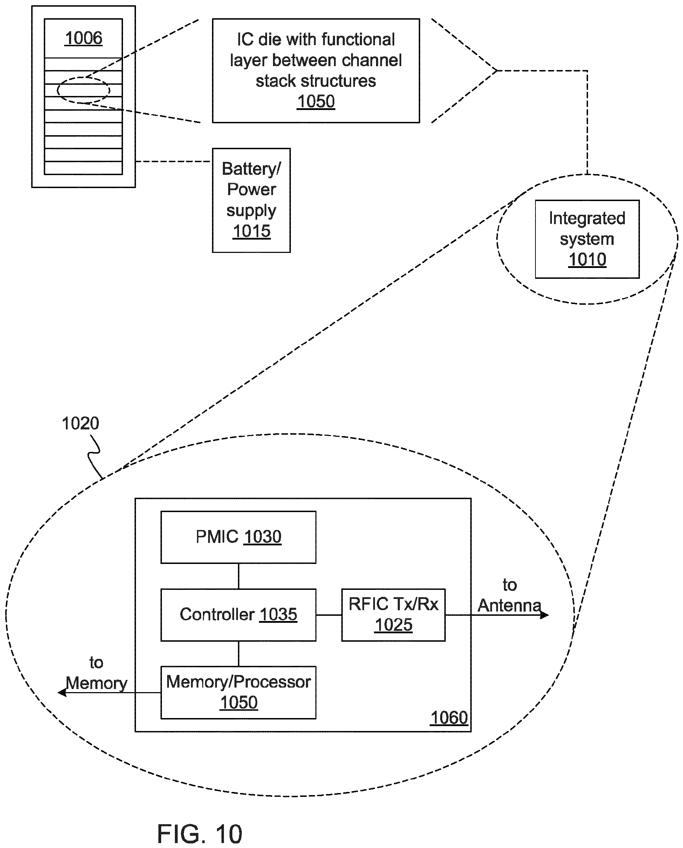

FIG. 10 illustrates a diagram of an example data server machine 1006 employing an IC die with FBVCs, in accordance with some embodiments. Server machine 1006 may be any commercial server, for example, including any number of high-performance computing platforms disposed within a rack and networked together for electronic data processing, which in the exemplary embodiment includes one or more devices 1050 having FBVCs.

Also as shown, server machine 1006 includes a battery and/or power supply 1015 to provide power to devices 1050, and to provide, in some embodiments, power delivery functions such as power regulation. Devices 1050 may be deployed as part of a package-level integrated system 1010. Integrated system 1010 is further illustrated in the expanded view 1020. In the exemplary embodiment, devices 1050 (labeled "Memory/Processor") includes at least one memory chip (e.g., RAM), and/or at least one processor chip (e.g., a microprocessor, a multicore microprocessor, or graphics processor, or the like) having the characteristics discussed herein. In an embodiment, device 1050 is a microprocessor including a cache memory. As shown, device 1050 may be a multi-chip module employing one or more IC dies with FBVCs, as discussed herein. Device 1050 may be further coupled to (e.g., communicatively coupled to) a board, an interposer, or a substrate 1060 along with, one or more of a power management IC (PMIC) 1030, RF (wireless) IC (RFIC) 1025, including a wideband RF (wireless) transmitter and/or receiver (TX/RX) (e.g., including a digital baseband and an analog front end module further comprises a power amplifier on a transmit path and a low noise amplifier on a receive path), and a controller 1035 thereof. In some embodiments, RFIC 1025, PMIC 1030, controller 1035, and device 1050 include IC dies having FBVCs on substrate 1060 in a multi-chip module.

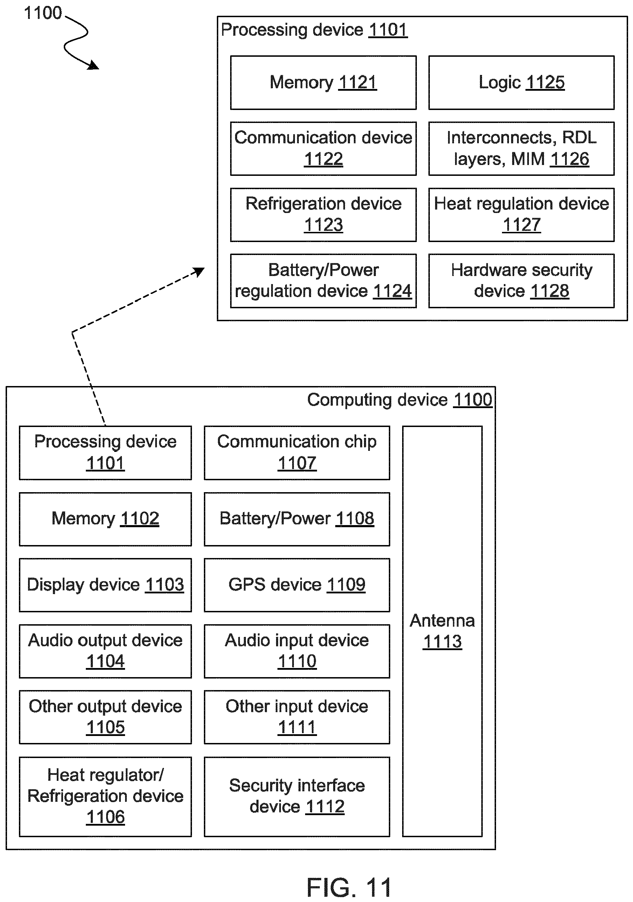

FIG. 11 is a block diagram of an example computing device 1100, in accordance with some embodiments. For example, one or more components of computing device 1100 may include any of the devices or structures discussed herein. A number of components are illustrated in FIG. 11 as being included in computing device 1100, but any one or more of these components may be omitted or duplicated, as suitable for the application. In some embodiments, some or all of the components included in computing device 1100 may be attached to one or more printed circuit boards (e.g., a motherboard). In some embodiments, various ones of these components may be fabricated onto a single system-on-a-chip (SoC) die. Additionally, in various embodiments, computing device 1100 may not include one or more of the components illustrated in FIG. 11, but computing device 1100 may include interface circuitry for coupling to the one or more components. For example, computing device 1100 may not include a display device 1103, but may include display device interface circuitry (e.g., a connector and driver circuitry) to which display device 1103 may be coupled. In another set of examples, computing device 1100 may not include an audio output device 1104, other output device 1105, global positioning system (GPS) device 1109, audio input device 1110, or other input device 1111, but may include audio output device interface circuitry, other output device interface circuitry, GPS device interface circuitry, audio input device interface circuitry, audio input device interface circuitry, to which audio output device 1104, other output device 1105, GPS device 1109, audio input device 1110, or other input device 1111 may be coupled.

Computing device 1100 may include a processing device 1101 (e.g., one or more processing devices). As used herein, the term "processing device" or "processor" indicates a device that processes electronic data from registers and/or memory to transform that electronic data into other electronic data that may be stored in registers and/or memory. Processing device 1101 may include a memory 1121, a communication device 1122, a refrigeration device 1123, a battery/power regulation device 1124, logic 1125, interconnects 1126 (i.e., optionally including redistribution layers (RDL) or MIM devices), a heat regulation device 1127, and a hardware security device 1128.

Processing device 1101 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 1100 may include a memory 1102, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 1102 includes memory that shares a die with processing device 1101. This memory may be used as cache memory and may include embedded dynamic random-access memory (eDRAM) or spin transfer torque magnetic random-access memory (STT-M RAM).

Computing device 1100 may include a heat regulation/refrigeration device 1106. Heat regulation/refrigeration device 1106 may maintain processing device 1101 (and/or other components of computing device 1100) at a predetermined low temperature during operation. This predetermined low temperature may be any temperature discussed herein.

In some embodiments, computing device 1100 may include a communication chip 1107 (e.g., one or more communication chips). For example, the communication chip 1107 may be configured for managing wireless communications for the transfer of data to and from computing device 1100. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 1107 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 1107 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 1107 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 1107 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 1107 may operate in accordance with other wireless protocols in other embodiments. Computing device 1100 may include an antenna 1113 to facilitate wireless communications and/or to receive other wireless communications (such as AM or FM radio transmissions).

In some embodiments, communication chip 1107 may manage wired communications, such as electrical, optical, or any other suitable communication protocols (e.g., the Ethernet). As noted above, communication chip 1107 may include multiple communication chips. For instance, a first communication chip 1107 may be dedicated to shorter-range wireless communications such as Wi-Fi or Bluetooth, and a second communication chip 1107 may be dedicated to longer-range wireless communications such as GPS, EDGE, GPRS, CDMA, WiMAX, LTE, EV-DO, or others. In some embodiments, a first communication chip 1107 may be dedicated to wireless communications, and a second communication chip 1107 may be dedicated to wired communications.

Computing device 1100 may include battery/power circuitry 1108. Battery/power circuitry 1108 may include one or more energy storage devices (e.g., batteries or capacitors) and/or circuitry for coupling components of computing device 1100 to an energy source separate from computing device 1100 (e.g., AC line power).

Computing device 1100 may include a display device 1103 (or corresponding interface circuitry, as discussed above). Display device 1103 may include any visual indicators, such as a heads-up display, a computer monitor, a projector, a touchscreen display, a liquid crystal display (LCD), a light-emitting diode display, or a flat panel display, for example.

Computing device 1100 may include an audio output device 1104 (or corresponding interface circuitry, as discussed above). Audio output device 1104 may include any device that generates an audible indicator, such as speakers, headsets, or earbuds, for example.

Computing device 1100 may include an audio input device 1110 (or corresponding interface circuitry, as discussed above). Audio input device 1110 may include any device that generates a signal representative of a sound, such as microphones, microphone arrays, or digital instruments (e.g., instruments having a musical instrument digital interface (MIDI) output).

Computing device 1100 may include a GPS device 1109 (or corresponding interface circuitry, as discussed above). GPS device 1109 may be in communication with a satellite-based system and may receive a location of computing device 1100, as known in the art.

Computing device 1100 may include other output device 1105 (or corresponding interface circuitry, as discussed above). Examples of the other output device 1105 may include an audio codec, a video codec, a printer, a wired or wireless transmitter for providing information to other devices, or an additional storage device.

Computing device 1100 may include other input device 1111 (or corresponding interface circuitry, as discussed above). Examples of the other input device 1111 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 1100 may include a security interface device 1112. Security interface device 1112 may include any device that provides security measures for computing device 1100 such as intrusion detection, biometric validation, security encode or decode, access list management, malware detection, or spyware detection.

Computing device 1100, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1-11. The subject matter may be applied to other deposition applications, as well as any appropriate manufacturing application, as will be understood to those skilled in the art.

The following examples pertain to further embodiments, and specifics in the examples may be used anywhere in one or more embodiments.

Example 1 includes an integrated circuit (IC) die, comprising a plurality of front-side metallization layers including a first front-side metallization layer and one or more additional front-side metallization layers, a plurality of back-side metallization layers formed on the plurality front side metallization layers including a first back-side metallization layer and one or more additional back-side metallization layers, wherein the first front-side metallization layer is proximate to the first back-side metallization layer, and a vertical metallization structure formed through at least the first front-side metallization layer and the first back-side metallization layer, wherein the vertical metallization structure electrically connects a first metallization structure on one of the one or more additional front-side metallization layers to a second metallization structure on one of the one or more additional back-side metallization layers.

Example 2 includes the IC die of Example 1, further comprising a cylindrical capacitor structure formed in the vertical metallization structure.

Example 3 includes the IC die of Example 2, wherein the cylindrical capacitor structure comprises a cylindrical metal-insulator-metal (MIM) capacitor structure.

Example 4 includes the IC die of Example 3, wherein one of the first metallization structure and the second metallization structure is to be coupled to a power source.

Example 5 includes the IC die of Example 4, wherein the cylindrical MIM capacitor structure is formed proximate to a component that has an expected surge in power demand.

Example 6 includes a system, comprising a substrate, a power supply, and an integrated circuit (IC) die attached to the substrate and coupled to the power supply, the IC die comprising a plurality of front-side metallization layers including a first front-side metallization layer and one or more additional front-side metallization layers, a plurality of back-side metallization layers formed on the plurality front side metallization layers including a first back-side metallization layer and one or more additional back-side metallization layers, wherein the first front-side metallization layer is proximate to the first back-side metallization layer, and a vertical metallization structure formed through at least the first front-side metallization layer and the first back-side metallization layer, wherein the vertical metallization structure electrically connects a first metallization structure on one of the one or more additional front-side metallization layers to a second metallization structure on one of the one or more additional back-side metallization layers.

Example 7 includes the system of Example 6, further comprising a cylindrical capacitor structure formed in the vertical metallization structure.

Example 8 includes the system of Example 7, wherein the cylindrical capacitor structure comprises a cylindrical metal-insulator-metal (MIM) capacitor structure.

Example 9 includes the system of Example 8, wherein one of the first metallization structure and the second metallization structure is to be coupled to a power source.

Example 10 includes the system of Example 9, wherein the cylindrical MIM capacitor structure is formed proximate to a component that has an expected surge in power demand.

Example 11 includes the system of Example 8, further comprising a plurality of cylindrical MIM capacitors formed through the first front-side metallization layer and the first back-side metallization layer respectively formed proximate to a plurality of components that have an expected surge in power demand.

Example 12 includes a method, comprising receiving a substrate, forming a plurality of front-side metallization layers on the substrate including a first front-side metallization layer and one or more additional front-side metallization layers, forming a plurality of back-side metallization layers on the plurality front side metallization layers including a first back-side metallization layer and one or more additional back-side metallization layers, wherein the first front-side metallization layer is proximate to the first back-side metallization layer, and forming a vertical metallization structure through at least the first front-side metallization layer and the first back-side metallization layer, wherein the vertical metallization structure electrically connects a first metallization structure on one of the one or more additional front-side metallization layers to a second metallization structure on one of the one or more additional back-side metallization layers.

Example 13 includes the method of Example 12, wherein forming the vertical metallization structure further comprises forming a hole between the first metallization structure and the second metallization structure, and depositing metal in the hole.

Example 14 includes the method of Example 13, wherein forming the hole further comprises breakthrough etching each intervening layer between the first metallization structure and the second metallization structure.

Example 15 includes the method of any of Examples 12 to 14, further comprising forming a cylindrical capacitor structure in the vertical metallization structure.

Example 16 includes the method of Example 15, wherein forming the cylindrical capacitor structure in the vertical metallization structure further comprises forming a hole between the first metallization structure and the second metallization structure, depositing a metal liner in the hole, depositing a dielectric liner on the metal liner, and depositing metal in the dielectric liner.

Example 17 includes the method of Example 16, wherein forming the hole further comprises breakthrough etching each intervening layer between the first metallization structure and the second metallization structure.

Example 18 includes the method of Example 17, wherein the cylindrical capacitor structure comprises a cylindrical metal-insulator-metal (MIM) capacitor structure.

Example 19 includes the method of Example 18, wherein one of the first metallization structure and the second metallization structure is to be coupled to a power source.

Example 20 includes the method of Example 19, wherein the cylindrical MIM capacitor structure is formed proximate to a component that has an expected surge in power demand.

Example 21 includes an apparatus, comprising means for receiving a substrate, means for forming a plurality of front-side metallization layers on the substrate including a first front-side metallization layer and one or more additional front-side metallization layers, means for forming a plurality of back-side metallization layers on the plurality front side metallization layers including a first back-side metallization layer and one or more additional back-side metallization layers, wherein the first front-side metallization layer is proximate to the first back-side metallization layer, and means for forming a vertical metallization structure through at least the first front-side metallization layer and the first back-side metallization layer, wherein the vertical metallization structure electrically connects a first metallization structure on one of the one or more additional front-side metallization layers to a second metallization structure on one of the one or more additional back-side metallization layers.

Example 22 includes the apparatus of Example 21, wherein the means for forming the vertical metallization structure further comprises means for forming a hole between the first metallization structure and the second metallization structure, and means for depositing metal in the hole.

Example 23 includes the apparatus of Example 22, wherein the means for forming the hole further comprises means for breakthrough etching each intervening layer between the first metallization structure and the second metallization structure.

Example 24 includes the apparatus of any of Examples 21 to 23, further comprising means for forming a cylindrical capacitor structure in the vertical metallization structure.

Example 25 includes the apparatus of Example 24, wherein the means for forming the cylindrical capacitor structure in the vertical metallization structure further comprises means for forming a hole between the first metallization structure and the second metallization structure, means for depositing a metal liner in the hole, means for depositing a dielectric liner on the metal liner, and means for depositing metal in the dielectric liner.

Example 26 includes the apparatus of Example 25, wherein the means for forming the hole further comprises means for breakthrough etching each intervening layer between the first metallization structure and the second metallization structure.

Example 27 includes the apparatus of Example 26, wherein the cylindrical capacitor structure comprises a cylindrical metal-insulator-metal (MIM) capacitor structure.

Example 28 includes the apparatus of Example 27, wherein one of the first metallization structure and the second metallization structure is to be coupled to a power source.

Example 29 includes the apparatus of Example 28, wherein the cylindrical MIM capacitor structure is formed proximate to a component that has an expected surge in power demand.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

**1.** An integrated circuit (IC) die, comprising:
a plurality of front-side metallization layers including a first front-side metallization layer and one or more additional front-side metallization layers;
a plurality of back-side metallization layers on the plurality front side metallization layers including a first back-side metallization layer and one or more additional back-side metallization layers, wherein the first front-side metallization layer is proximate to the first back-side metallization layer; and
a vertical metallization structure through at least the first front-side metallization layer and the first back-side metallization layer, wherein the vertical metallization structure electrically connects a first metallization structure on one of the one or more additional front-side metallization layers to a second metallization structure on one of the one or more additional back-side metallization layers.

**2.** The IC die of claim 1, further comprising:
a cylindrical capacitor structure in the vertical metallization structure.

**3.** The IC die of claim 2, wherein the cylindrical capacitor structure comprises a cylindrical metal-insulator-metal (MIM) capacitor structure.

**4.** The IC die of claim 3, wherein one of the first metallization structure and the second metallization structure is to be coupled to a power source.

**5.** The IC die of claim 4, wherein the cylindrical MIM capacitor structure is proximate to a component that has an expected surge in power demand.

**7.** A method, comprising:
receiving a substrate;
forming a plurality of front-side metallization layers on the substrate including a first front-side metallization layer and one or more additional front-side metallization layers;
forming a plurality of back-side metallization layers on the plurality front side metallization layers including a first back-side metallization layer and one or more additional back-side metallization layers, wherein the first front-side metallization layer is proximate to the first back-side metallization layer; and
forming a vertical metallization structure through at least the first front-side metallization layer and the first back-side metallization layer, wherein the vertical metallization structure electrically connects a first metallization structure on one of the one or more additional front-side metallization layers to a second metallization structure on one of the one or more additional back-side metallization layers.

**8.** The method of claim 7, wherein forming the vertical metallization structure further comprises:
forming a hole between the first metallization structure and the second metallization structure; and
depositing metal in the hole.

**9.** The method of claim 8, wherein forming the hole further comprises:
breakthrough etching each intervening layer between the first metallization structure and the second metallization structure.

**10.** The method of any of claims 7 to 9, further comprising:
forming a cylindrical capacitor structure in the vertical metallization structure.

**11.** The method of claim 10, wherein forming the cylindrical capacitor structure in the vertical metallization structure further comprises:
forming a hole between the first metallization structure and the second metallization structure;
depositing a metal liner in the hole;
depositing a dielectric liner on the metal liner; and
depositing metal in the dielectric liner.

**12.** The method of claim 11, wherein forming the hole further comprises:
breakthrough etching each intervening layer between the first metallization structure and the second metallization structure.

**13.** The method of claim 12, wherein the cylindrical capacitor structure comprises a cylindrical metal-insulator-metal (MIM) capacitor structure.

**14.** The method of claim 13, wherein one of the first metallization structure and the second metallization structure is to be coupled to a power source.

**15.** The method of claim 14, wherein the cylindrical MIM capacitor structure is proximate to a component that has an expected surge in power demand.
